# EUROPÄISCHE PATENTSCHRIFT

(11) **EP 2 381 572 B1**
(45) Veröffentlichungstag und Bekanntmachung des Hinweises auf die Patenterteilung: **08.05.2019**
(21) Anmeldenummer: 11156122.1
(22) Anmeldetag: 28.02.2011
(51) Int. Cl.: H02M 7/06, H01L 29/872

(54) **VERWENDUNG VON TRENCH-MOS-BARRIER-SCHOTTKY-DIODEN (TMBS) ALS GLEICHRICHTENDE ELEMENTE EINER GLEICHRICHTER-BRÜCKENSCHALTUNG EINES KRAFTFAHRZEUGGENERATORS**
UTILISATION OF TRENCH-MOS-BARRIER-SCHOTTKY-DIODES (TMBS) AS RECTIFYING ELEMENTS OF A RECTIFIER BRIDGE CIRCUIT FOR AN ELECTRIC GENERATOR OF A CAR
UTILISATION DE DIODES SCHOTTKY À BARRIÈRE MOS EN TRANCHÉE (TMBS) COMME ÉLÉMENTS REDRESSEURS D'UN REDRESSEUR À PONT D'UN GÉNÉRATEUR DE VÉHICULE AUTOMOBILE

(30) Priorität: 26.04.2010 DE 102010028203
(43) Veröffentlichungstag der Anmeldung: 26.10.2011
(73) Patentinhaber: Robert Bosch GmbH, 70442 Stuttgart (DE); SEG Automotive Germany GmbH, 70499 Stuttgart (DE)
(72) Erfinder: Spitz, Richard, 72766 Reutlingen (DE); Goerlach, Alfred, 72127 Kusterdingen (DE)

(56) Entgegenhaltungen:
- EP-A1- 1 675 184
- WO-A1-01/11693
- WO-A1-01/63671
- DE-A1-102004 053 760
- DE-A1-102004 056 663
- Max Chen ET AL: "High-Voltage TMBS Diodes Challenge Planar Schottkys", , 31 October 2006 (2006-10-31), pages 22-32, XP055128222, Retrieved from the Internet: URL:http://powerelectronics.com/mag/610PET 21.pdf [retrieved on 2014-07-10]

## Beschreibung

Die Erfindung betrifft eine Verwendung von Trench-MOS-Barrier-Schottky-Dioden (TMBS) als gleichrichtende Elemente einer Gleichrichter-Brückenschaltung eines Kraftfahrzeuggenerators.

### Stand der Technik

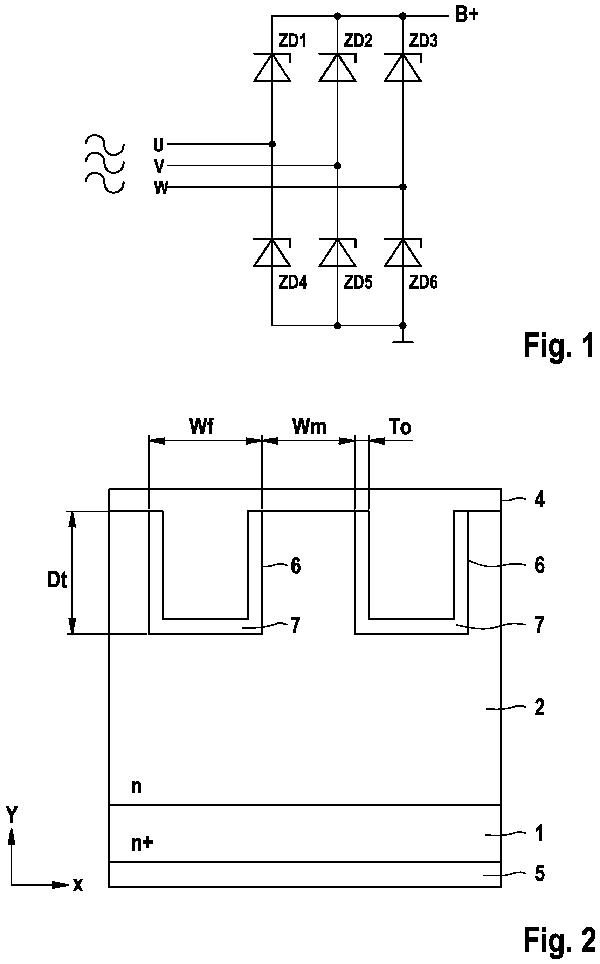

Bei Wechselstromgeneratoren (Lichtmaschinen) werden zur Gleichrichtung Wechselstrombrücken verwendet. Beispielsweise werden bei 3-phasigen Drehstromsystemen sogenannte B6-Brücken verwendet, die als gleichrichtende Elemente sechs pn-Halbleiterdioden aus Silizium enthalten. Eine derartige B6-Brücke ist in der Figur 1 dargestellt. Die Halbleiterdioden werden üblicherweise als Z-Dioden ausgelegt. Neben 3-phasigen Systemen werden auch Wechselstromgeneratoren mit einer anderen Phasenzahl verwendet. Die als Gleichrichter verwendeten Brücken sind dann entsprechend aufgebaut. Ein komplettes Generatorsystem enthält neben dem Generator und der Wechselstrombrücke noch einen Spannungsregler, der dafür sorgt, dass die gleichgerichtete Spannung einen bestimmten Wert, beispielsweise 14,3 V, aufweist. Außerdem ist noch ein Entstörkondensator von beispielsweise 2,2 µF zwischen B+ und Masse geschaltet. Regler, Drehstromgenerator und Kondensator sind in der Figur 1 nicht eingezeichnet.

Die Z-Dioden sind für den Betrieb bei hohen Strömen in Flussrichtung, wobei Stromdichten bis etwa 500 A/cm² auftreten, und bei hohen Temperaturen ausgelegt. Typischerweise beträgt der Spannungsabfall in Flussrichtung, die Flussspannung UF, bei den verwendeten hohen Strömen ca. 1 Volt. Bei Betrieb in Sperrrichtung fließt dagegen nur ein sehr kleiner Sperrstrom IR bis zu einer Durchbruchsspannung UZ. Ab dieser Spannung steigt der Sperrstrom sehr stark an. Ein weiterer Spannungsanstieg wird deshalb verhindert.

Die Durchbruchsspannungen der Z-Dioden liegen im Fall eines 12 V Bordnetzes oberhalb der Generatorspannung in einem Bereich von etwa 19-26 V. Die Z-Dioden sind so ausgelegt, dass sie kurzzeitig mit sehr hohen Strömen im Durchbruch belastet werden können. Sie bieten dadurch einen Schutz des Bordnetzes und des Reglers gegen Überspannungen bei plötzlich ansteigender Generatorspannung, indem sie die Generatorspannung begrenzen. Die Generatorspannung steigt bei plötzlichen Lastwechseln dann besonders stark an, wenn ein großer Lastwechsel bei nicht angeschlossener oder defekter Batterie auftritt (Loaddump).

Im Fall eines Loaddumps steigt die Spannung an den Phasen des Generators an, bis die Durchbruchsspannungen der Z-Dioden erreicht sind. Für die Differenz zwischen zwei Phasenspannungen gilt: Strangspannung = UF + UZ. Der Strom fließt dann als Durchbruchsstrom über die Z-Dioden, die sich gerade in Sperrrichtung befinden. Dabei ist immer eine Diode in Flussrichtung und eine Diode in Durchbruchsrichtung in Reihe geschaltet. Im Fall der B6-Brücke teilt sich der Generatorstrom üblicherweise so auf, dass er beispielsweise von einer Plusdiode und zwei Minusdioden in Durchbruchsrichtung getragen wird und in der folgenden Phase von zwei Plusdioden und einer Minusdiode. Im Extremfall, wenn eine Phase Null ist, befindet sich eine Plus- und eine Minusdiode im Durchbruch. Wenn der Regler den Spannungsanstieg erkennt, schaltet er den Erregerstrom ab. Da das Magnetfeld der Erregerwicklung aber nicht schlagartig verschwindet, klingt die erhöhte Generatorspannung nur relativ langsam mit einer Zeitdauer von ca. 100-400 ms ab. Die an der Klemme B+ gemessene Generatorspannung UB+ wird auf UZ - UF begrenzt.

Während eines Loaddumps fließen sehr hohe Durchbruchsströme durch die Dioden. Im Fall eines vollen Loaddumps, d. h. eines vollständigen Batterie- und Lastabwurfes, wird der gesamte Generatorstrom von den Dioden im Durchbruch übernommen. Die Energie UZ * IZ wird in den Dioden in Wärme umgewandelt. Deshalb steigt die Junctiontemperatur Tj der Dioden kurzzeitig stark an. Üblicherweise werden für diese Ereignisse Temperaturen Tj weit oberhalb der maximal zulässigen Dioden-Betriebstemperatur spezifiziert. Um den Temperaturanstieg abzupuffern werden die Z-Dioden in Einpressdiodengehäuse verpackt, wie es beispielsweise in der DE 102 42 521 A1 beschrieben ist. Dabei ist der eine Anschluss der Dioden als Anschlussdraht herausgeführt, während der andere Anschluss aus einem runden Metallsockel besteht, der in eine vorhandene Bohrung einer Kühlplatte des Gleichrichters eingepresst wird und für eine gute thermische und elektrische Verbindung sorgt. Die beidseitige thermische Anbindung wirkt als Wärmekapazität und puffert den Temperaturanstieg im Loaddump effektiv ab.

Idealerweise sind die Durchbruchsspannungen aller Z-Dioden in der Brücke identisch, zumindest sofern alle Dioden vor dem Loaddump dieselbe Temperatur aufweisen.

Für den Fall identischer Durchbruchsspannungen fällt an den Dioden kurzzeitig maximal der halbe Generatorstrom ab. Wegen unvermeidbarer Fertigungsschwankungen sind jedoch nicht alle Z-Spannungen UZ der Dioden innerhalb eines Gleichrichters identisch. Dies führt zu ungleichmäßigen Belastungen der Dioden im Durchbruch und damit zu einer insgesamt reduzierten Loaddumpfestigkeit des Generators.

Eine gewisse Entlastung kann durch das Temperaturverhalten der Durchbruchsspannung bewirkt werden, da die Durchbruchsspannung bei Z-Dioden mit zunehmender Temperatur ansteigt (positiver Temperaturkoeffizient).

Beim Einsetzen eines Loaddumps gerät die Diode mit der niedrigsten Durchbruchsspannung UZ zuerst in den Durchbruch. Es fließt mehr Strom durch diese Diode als durch die weiteren Dioden. Dadurch heizt sie sich stärker auf und gleicht Ihre Durchbruchsspannung UZ etwas an die der anderen Dioden an. Allerdings ist dieser Effekt meist nicht ausreichend, um völlig symmetrische Strom- und Spannungsverteilungen einzustellen.

Aus der DE 10 2004 056 663 A1 sind Gleichrichteranordnungen mit Trench-MOS-Barrier-Schottky-Dioden (TMBS) bekannt, in welche als zusätzliche Schutzelemente für den Betrieb im Durchbruch Z-Dioden oder integrierte pn-Übergänge eingebracht sind.

In "High-Voltage TMBS Diodes Challenge Planar Schottkys", "Max Chen et al., wird die Verwendung von TMBS-Dioden in Schaltgleichrichtern beschrieben.

### Offenbarung der Erfindung

Die Erfindung betrifft eine Verwendung von Trench-MOS-Barrier-Schottky-Dioden (TMBS) als gleichrichtende Elemente einer Gleichrichter-Brückenschaltung eines Kraftfahrzeuggenerators gemäß Anspruch 1.

Eine solche Gleichrichter-Brückenschaltung weist als gleichrichtende Elemente statt der üblichen Z-Dioden Elemente auf, bei denen sich die Durchbruchsspannung UZ bei Betrieb im Durchbruch erhöht. Dadurch erreicht man identische Durchbruchsspannungen der Dioden im Gleichrichter, selbst wenn die Durchbruchsspannungen der Dioden vor dem Betrieb unterschiedlich
sind. Im Fall eines Loaddumps wird die Loaddumpenergie gleichmäßig auf alle Dioden verteilt und damit die erzielbare Loaddumpenergie maximiert.

Insbesondere werden anstelle von einfachen Z-Dioden in Gleichrichtern, die im Wesentlichen eine pn-Halbleiterstruktur darstellen, Elemente vorgeschlagen, die als Klammerelement eine Struktur verwenden, bei der sich die Durchbruchsspannung beim Betrieb im Durchbruch erhöht. Als Klammerelement wird vorzugsweise eine Metall-Oxid-Halbleiterstruktur verwendet. Für den Einsatz im Gleichrichter wird als besonders vorteilhaft eine Trench-MOS-Barrier-Schottky-Diode (TMBS) - also eine Kombination von Schottky-Diode und Trench-MOS-Struktur - vorgeschlagen. Diese Anordnung hat daneben noch den Vorteil, dass die Flussspannung niedriger als bei pn-Dioden eingestellt werden kann. Beispielsweise kann eine Flussspannung zwischen 0,5 V und 0,7 V bei 500 A/cm² erreicht werden.

Die Figur 2 zeigt als ein erstes Ausführungsbeispiel eine als Chip realisierte TMBS bestehend aus einem n+-Substrat 1, einer n-Epischicht 2, mindestens zwei in der n-Epischicht 2 durch Ätzen realisierte Gräben (Trenchs) 6, Metallschichten an der Vorderseite 4 des Chips als Anodenelektrode und an der Rückseite 5 des Chips als Kathodenelektrode, und Oxidschichten 7 zwischen den Gräben 6 und den Metallschichten. Elektrisch gesehen ist die TMBS eine Kombination von einer MOS-Struktur (Metallschicht, Oxidschichten 7 und n-Epischicht 2) und einer Schottky-Diode (Schottky-Barriere zwischen der Metallschicht als Anode und der n-Epischicht 2 als Kathode).

In Flussrichtung fließen Ströme durch den Mesa-Bereich zwischen den Gräben 6. Die Gräben 6 selbst stehen für den Stromfluss nicht zur Verfügung. Eine TMBS weist sehr niedrige Sperrströme auf. In der Sperrrichtung bilden sich sowohl bei der MOS-Struktur als auch bei der Schottky-Diode Raumladungszonen aus. Die Raumladungszonen dehnen sich mit steigender Spannung aus und stoßen bei einer Spannung, die kleiner als die Durchbruchspannung der TMBS ist, in der Mitte des Bereichs zwischen den benachbarten Gräben 6 zusammen. Dadurch werden die für hohe Sperrströme verantwortlichen Schottky-Effekte abgeschirmt und die Sperrströme reduziert. Dieser Abschirmeffekt ist stark von Strukturparametern Dt (Tiefe des Grabens), Wm (Abstand zwischen den Gräben), Wt (Breite des Grabens) sowie von To (Dicke der Oxidschicht) abhängig.

Im Rahmen der Herstellung einer TMBS erfolgt ein Einbringen der Gräben 6 durch Ätzen der n-Epischicht 2, Wachsen der Oxidschicht 7 und Ausfüllen der Gräben mit leitfähigen, dotierten Schichten aus Polysilizium. Alternativ können die Gräben mit Metall gefüllt werden. Die Ausdehnung der Raumladungszonen im Mesa-Bereich zwischen den Gräben 6 ist quasi-eindimensional, sofern die Tiefe Dt des Grabens deutlich größer als der Abstand Wm zwischen den Gräben ist.

Beim Sperrspannungsdurchbruch entstehen sehr hohe elektrische Felder innerhalb der Oxidschicht 7 in der Nähe des Trenchbodens und direkt in der Nähe der Oxidschicht in der n-Epischicht 2. Als Folge werden beim Sperrspannungs- oder Avalance-Durchbruch heiße Ladungsträger von der n-Epischicht 2 in die Oxidschicht 7 der MOS-Struktur injiziert. In der gezeigten Anordnung mit einer n-dotierten Epischicht 2 handelt es sich um Löcher. Als Folge dieses Prozesses verbleiben positive Ladungen in der Oxidschicht und schirmen das von außen angelegte elektrische Feld der Sperrspannung ab. Um die Durchbruchfeldstärke im Silizium zu erreichen wird deshalb ein höheres externes Feld bzw. eine höhere externe Spannung benötigt. Die Durchbruchsspannung der TMBS-Struktur steigt an.

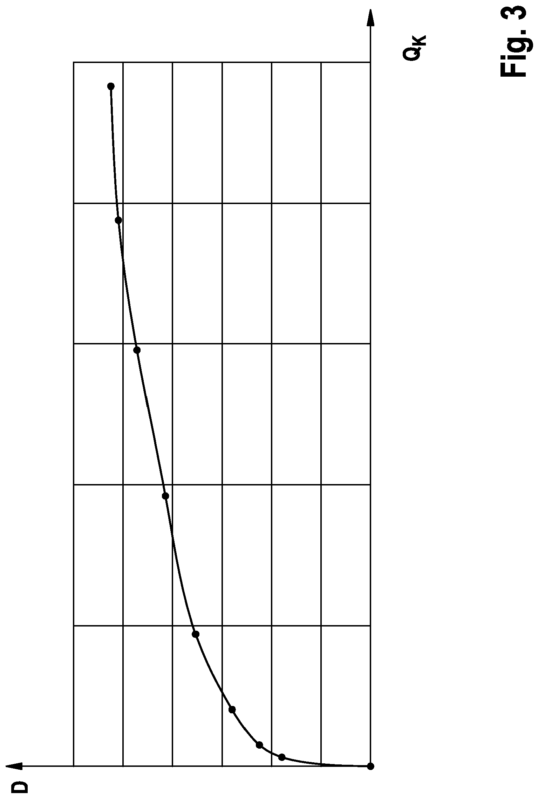

In besonders vorteilhafter Weise wird für das Schottky-Metall an der Vorderseite 4 des Chips Nickel oder Nickelsilizid verwendet. Dadurch gelingt es niedrige Flussspannungen im Bereich von 0,5 V - 0,7 V bei gleichzeitig niedrigen Sperrströmen einzustellen. Es hat sich in vorteilhafter Weise gezeigt, dass TMBS-Strukturen bei hohen Strömen im Durchbruch betrieben werden können, ohne dass es zu einer Zerstörung der Diode kommt. Die Sperrspannung driftet dabei nach oben, wobei die Zunahme der Spannung mit der Zeit abnimmt. Dies ist in der Figur 3 veranschaulicht, in welcher das Verhalten der Spannungsdrift D einer TMBS in Abhängigkeit von der kumulierten Durchbruchsladung Q_{K} veranschaulicht ist. Die kumulierte Durchbruchsladung entsteht mit zunehmender Zeit im Durchbruchsbetrieb bei abfallender Durchbruchsleistung UZ * IZ.

Werden nun beispielsweise in einer B6-Brücke gemäß Fig.1 die Dioden ZD1 bis ZD6 durch TMBS-Dioden gemäß Fig.2, die ein Driftverhalten der Sperrspannung gemäß Fig.3 zeigen, ersetzt, dann gleichen sich die Durchbruchsspannungen der TMBS-Dioden bei Betrieb im Durchbruch an. Die Loaddumpfestigkeit eines Kraftfahrzeuggenerators, von welchem die Gleichrichter-Brückenschaltung Bestandteil ist, wird erhöht. Natürlich können auch Gleichrichter für Wechselstromgeneratoren mit mehr als drei Phasen, z.B. mit 5, 6 oder 7 Phasen, mit Elementen gemäß der Figur 2 bestückt werden. Wie Loaddump-Messungen an Generatoren zeigen, kann etwa 20% mehr Loaddumpstrom abgeschaltet werden.

Ein weiteres Ausführungsbeispiel für eine Kombination einer gleichrichtenden Struktur und einer Trench-MOS-Struktur, die Spannungsdrift im Durchbruch zeigt, besteht darin, zwischen Metall an der Vorderseite 4 und n-Silizium 2 in Figur 2 eine p-Schicht einzufügen, deren Durchbruchsspannung UZPN größer ist als die Durchbruchsspannung der MOS-Struktur UZMOS.

Des Weiteren können anstelle der Trench-MOS-Strukturen auch flächig verteilte planare MOS-Strukturen verwendet werden, wobei der Sperrspannungsdurchbruch wieder an der MOS-Struktur stattfindet.

Eine Gleichrichter-Brückenschaltung gemäß der vorliegenden Erfindung kann insbesondere in Wechselstromgeneratoren mit Rekuperationsbetrieb verwendet werden.

## Patentansprüche

1. Verwendung von Trench-MOS-Barrier-Schottky-Dioden (TMBS) als gleichrichtende Elemente einer Gleichrichter-Brückenschaltung eines Kraftfahrzeuggenerators, die eine Drift der Sperrspannung aufweisen, wenn sie im Durchbruch betrieben werden, wobei die Trench-MOS-Barrier-Schottky-Dioden (TMBS)bei Betrieb im Durchbruch die Durchbruchspannung UZ erhöhen, wobei sich die Durchbruchsspannungen der Trench-MOS-Barrier-Schottky-Dioden (TMBS) bei Betrieb der Gleichrichter-Brückenschaltung im Durchbruch angleichen.

2. Verwendung nach Anspruch 1, **dadurch gekennzeichnet, dass** es sich bei den gleichrichtenden Elementen um Trench-MOS-Barrier-Schottky-Dioden (TMBS) mit einer Schottky-Barriere von etwa 0,65 eV bis 0,7 eV handelt.

3. Verwendung nach einem der vorhergehenden Ansprüche, **dadurch gekennzeichnet, dass** es sich bei den gleichrichtenden Elementen um Trench-MOS-Barrier-Schottky-Dioden (TMBS) mit einem Schottky-Barrierenmetall aus Nickel oder Nickelsilizid handelt.

4. Verwendung nach einem der vorhergehenden Ansprüche, **dadurch gekennzeichnet, dass** es sich bei den gleichrichtenden Elementen um Trench-MOS-Barrier-Schottky-Dioden (TMBS) handelt, bei denen die Gräben etwa 1 - 3 µm und der Abstand von Graben zu Graben etwa 0,5 - 1 µm beträgt.

5. Verwendung nach einem der vorhergehenden Ansprüche, **dadurch gekennzeichnet, dass** die MOS-Strukturen gleichmäßig über einen Chip verteilt angeordnet sind.

6. Verwendung nach einem der vorhergehenden Ansprüche, **dadurch gekennzeichnet, dass** mindestens eines der gleichrichtenden Elemente als Einpressdiode ausgeführt ist.

## Claims

1. Use of trench MOS barrier Schottky diodes (TMBS) as rectifying elements of a rectifier bridge circuit of a motor vehicle generator which have a drift of the reverse voltage if they are operated at breakdown, wherein the trench MOS barrier Schottky diodes (TMBS) increase the breakdown voltage UZ during operation at breakdown, wherein the breakdown voltages of the trench MOS barrier Schottky diodes (TMBS) match one another during operation of the rectifier bridge circuit at breakdown.

2. Use according to Claim 1, **characterized in that** the rectifying elements are trench MOS barrier Schottky diodes (TMBS) having a schottky barrier of approximately 0.65 eV to 0.7 eV.

3. Use according to either of the preceding claims, **characterized in that** the rectifying elements are trench MOS barrier Schottky diodes (TMBS) comprising a Schottky barrier metal composed of nickel or nickel silicide.

4. Use according to any of the preceding claims, **characterized in that** the rectifying elements are trench MOS barrier Schottky diodes (TMBS) in which the trenches are approximately 1-3 µm and the distance from trench to trench is approximately 0.5-1 µm.

5. Use according to any of the preceding claims, **characterized in that** the MOS structures are arranged in a manner distributed uniformly over a chip.

6. Use according to any of the preceding claims, **characterized in that** at least one of the rectifying elements is embodied as a press-fit diode.

## Revendications

1. Utilisation de diodes Schottky à barrière MOS en tranchée (TMBS) en tant qu'éléments redresseurs d'un circuit redresseur en pont d'un générateur de véhicule automobile, qui présentent une dérive de la tension de blocage lorsqu'elles sont mises en fonctionnement en mode de claquage, dans lequel les diodes Schottky à barrière MOS en tranchée (TMBS), lors d'un fonctionnement en mode de claquage, augmentent la tension de claquage UZ, dans lequel les tensions de claquage des diodes Schottky à barrière MOS en tranchée (TMBS) s'égalisent lors d'un fonctionnement du circuit redresseur en pont en mode de claquage.

2. Utilisation selon la revendication 1, **caractérisée en ce que** les éléments redresseurs sont des diodes Schottky à barrière MOS en tranchée (TMBS) présentant une barrière Schottky d'environ 0,65 eV à 0,7 eV.

3. Utilisation selon l'une des revendications précédentes, **caractérisée en ce que** les éléments redresseurs sont des diodes Schottky à barrière MOS en tranchée (TMBS) présentant un métal de barrière Schottky constitué de nickel ou de siliciure de nickel.

4. Utilisation selon l'une des revendications précédentes, **caractérisée en ce que** les éléments redresseurs sont des diodes Schottky à barrière MOS en tranchée (TMBS) pour lesquelles les tranchées sont d'environ 1 - 3 µm et la distance d'une tranchée à l'autre est d'environ 0,5 - 1 µm.

5. Utilisation selon l'une des revendications précédentes, **caractérisée en ce que** les structures MOS sont disposées de manière répartie régulièrement sur une puce.

6. Utilisation selon l'une des revendications précédentes, **caractérisée en ce qu'**au moins l'un des éléments redresseurs est réalisé sous la forme d'une diode à ajustement forcé.
